# FASCICULE DE BREVET EUROPEEN

(11) **EP 1 419 680 B1**
(45) Date de publication et mention de la délivrance du brevet: **26.05.2010**
(21) Numéro de dépôt: 02758465.5
(22) Date de dépôt: 13.08.2002
(51) Int. Cl.: H05K 5/06

(54) **PROCEDE DE FABRICATION D'UNE UNITE D'IDENTIFICATION ET UNITE D'IDENTIFICATION FABRIQUEE A PARTIR DE CE PROCEDE**
VERFAHREN ZUR HERSTELLUNG EINER IDENTIFIKATIONSEINHEIT UND NACH DIESEM VERFAHREN HERGESTELLTE IDENTIFIKATIONSEINHEIT
METHOD FOR MAKING AN IDENTIFICATION UNIT AND IDENTIFICATION UNIT OBTAINED BY SAME

(30) Priorité: 23.08.2001 FR 0111277
(43) Date de publication de la demande: 19.05.2004
(73) Titulaire: VALEO SECURITE HABITACLE S.A.S., 94042 Créteil Cédex (FR)
(72) Inventeur: GARNAULT, Joel, F-95110 Sannois (FR); VARENNE, Jean-Philippe, 42, rue Le Corbusier,94042 Créteil Cedex (FR); GAS, Olivier, F-78110 Le Vesinet (FR)
(74) Mandataire: Rosolen-Delarue, Katell
(86) Numéro de dépôt international: PCT/EP2002/009061
(87) Numéro de publication internationale: WO 2003/020002

(56) Documents cités:
- DE-U- 20 015 259
- FR-A- 1 335 095
- US-A- 5 009 311

## Description

La présente invention concerne un procédé de fabrication d'une unité d'identification d'utilisateurs pour autoriser l'accès à un espace clos tel qu'un immeuble, un service ou un véhicule automobile ainsi que l'unité d'identification obtenue à partir de ce procédé.

La présente invention concerne, plus particulièrement, un procédé de fabrication d'unités d'identification pour autoriser le déverrouillage d'un véhicule équipé d'un système d'accès dit « mains-libres ». Un tel système comprend un calculateur, disposé dans le véhicule, qui échange des données d'identification avec une unité d'identification, ou badge, portée par un utilisateur.

Une unité d'identification de ce type est formée par deux parties de boîtier fixées l'une à l'autre par une soudure à ultrason (voir par exemple DE 20015259 U1). Ce type de soudure présente l'avantage de pouvoir être également réalisée sur des parties de boîtier préalablement décorées.

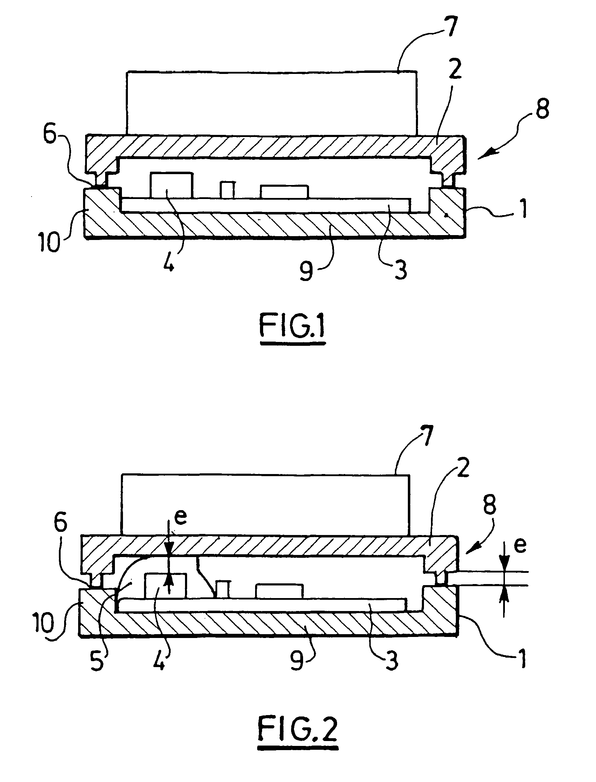

Pour mieux illustrer la présente invention, la demanderesse a représenté, sur la figure 1, une vue schématique en coupe transversale d'un dispositif d'identification pendant une étape de fixation des deux parties formant le boîtier de l'unité d'identification.

Classiquement, chaque partie de boîtier est formée par un support plan 9 entouré par un rebord 10. Une carte électronique 3 est disposée entre les deux parties 1, 2 de boîtier 8. Un circuit électronique est formé sur la carte électronique, à partir de composants électroniques 4 connectés entre eux. Ce circuit électronique réceptionne et émet des données d'identification avec le calculateur pour déverrouiller le véhicule.

Lorsque les deux parties de boîtier sont soudées par un procédé à ultrason, l'extrémité du rebord 10 d'une des parties de boîtier comporte une nervure de soudure 6 aussi appelé un directeur d'énergie. Cette nervure de soudure 6 est réalisée en matière plastique et est destinée à fondre pendant le procédé de soudure à ultrason.

La soudure à ultrason est obtenue par solidification de matière plastique en fusion. Un instrument, couramment appelé sonotrode, fait fondre la matière plastique par application de vibration à une fréquence d'environ 30kHz.

Typiquement, pour fixer les deux parties 1, 2 de boîtier, un sonotrode 7 est disposé sur une des deux parties 1 ou 2. Il transmet des vibrations à celle -ci de sorte que la nervure de soudure 6 fonde petit à petit et forme de la matière plastique liquide. Cette matière plastique se solidifie en se refroidissant et forme ainsi une excellente liaison entre la première 1 et la seconde partie 2 de boîtier.

Cependant, les vibrations transmises par le sonotrode 7 aux parties 1, 2 de boîtier sont également transmises à la carte électronique 3. Or, ces vibrations fragilisent les composants électroniques et leurs connexions ce qui conduit à des défaillances imputables par exemple, à des ruptures de patte de connexion. Ces unités d'identification, ainsi fragilisées, ne sont plus opérationnelles peu de temps après leur commercialisation.

Un but de la présente invention est de proposer un procédé de fabrication d'une unité d'identification dans lequel les composants électroniques sont mieux protégés contre l'action des ultrasons.

A cet effet, l'invention a pour objet un procédé de fabrication d'une unité d'identification, l'unité d'identification comportant une première et une seconde parties de boîtier et une carte électronique portant des composants électroniques destinés à être connectés entre eux, le rebord de l'une des deux parties de boîtier comportant une nervure en matière plastique pour permettre une soudure selon un procédé à ultrason, le procédé comportant les étapes suivantes :
- mise en place de la carte électronique dans une première partie de boîtier,
- assemblage de la seconde partie de boîtier sur la première partie de boîtier,
- fixation de la seconde partie de boîtier sur la première partie de boîtier par un procédé de soudure à ultrason, caractérisé en qu'il comporte avant l'étape d'assemblage, une étape intermédiaire de dépôt d'une épaisseur prédéfinie de matière élastique sur au moins une région de la carte électronique et/ou sur une des premières et secondes parties du boîtier, de sorte que pendant l'étape de fixation des deux parties de boîtier, la matière élastique protège les composants électroniques ainsi que leurs connexions en amortissant les vibrations qui leur sont communiquées.

Ainsi, avantageusement, les composants électroniques de la carte électronique ainsi que leurs connexions ne sont pas détériorés pendant l'étape de soudure à ultrason et l'unité d'identification résiste plus longtemps à son maniement et aux contraintes extérieures.

Le procédé selon l'invention peut comporter en outre une ou plusieurs des caractéristiques suivantes :
- la matière élastique est une mousse ou une silicone,
- la matière élastique est une colle, par exemple une colle bi-composant,
- la colle est destinée à être déposée sur le composant électronique qui est le plus proche de la surface intérieure de la seconde partie de boîtier et/ou en regard de celui-ci pour diminuer la quantité de colle nécessaire à amortir les vibrations induites lors de l'étape de fixation.
- il comporte, entre l'étape de dépôt et l'étape de fixation, une étape de polymérisation de la colle jusqu'à obtention d'un degré de viscosité tel que son état est d'une part suffisamment liquide pour que la colle s'étale entre les deux parties de boîtier sans déformation de celles-ci, et d'autre part suffisamment solide pour que la colle amortisse les vibrations communiquées aux composants électroniques ainsi qu'à leurs connexions.
- l'épaisseur prédéfinie de colle est environ égale à l'épaisseur de la nervure de soudure d'une des parties de boîtier, la seconde partie de boîtier étant en contact avec la colle tout au long de l'étape de fixation de manière à amortir les chocs communiqués aux composants électroniques et à étaler la colle de sorte qu'elle soit ajustée exactement entre la première et la deuxième parties de boîtier,
- il comporte une étape d'étuvage pour accélérer la vitesse de polymérisation de la colle.

L'invention a également pour objet une unité d'identification réalisée à partir d'une première et d'une seconde parties de boîtier fixées l'une à l'autre par un procédé de soudure à ultrason, une carte électronique portant des composants électroniques connectés entre eux et étant disposée à l'intérieur du boîtier, **caractérisée en ce qu'**une matière élastique est déposée avec une épaisseur prédéfinie sur au moins une région de la carte électronique de manière à amortir les vibrations engendrées par le procédé de soudure à ultrason et à protéger les composants électroniques ainsi que leurs connexions notamment durant le procédé de soudure.

L'unité d'identification selon l'invention peut comporter en outre une ou plusieurs des caractéristiques suivantes :
- la matière élastique est une mousse ou une silicone.
- la matière élastique est une colle, par exemple une colle bi-composant,
- la colle recouvre le composant électronique le plus épais de la carte électronique

L'invention sera mieux comprise au cours de la description explicative détaillée qui va suivre en référence :
- à figure 1 représentant schématiquement une vue transversale en coupe de la première et de la seconde parties de boîtier constituant le dispositif d'identification selon l'art antérieur,
- à la figure 2 représentant schématiquement une vue transversale en coupe de la première et de la seconde parties de boîtier constituant le dispositif d'identification selon la présente invention.

Selon la présente invention, le procédé de fabrication d'une unité comporte une étape supplémentaire de dépôt de matière élastique 5 sur une région de la carte électronique 3 pour amortir les vibrations transmises à la carte électronique 3 par la sonotrode.

Grâce au procédé selon la présente invention, la matière élastique disposée sur une région de la carte électronique agit comme un coussin qui amortit les vibrations communiquées à la carte électronique et, ainsi, protège les composants électroniques et leurs connexions.

En variante la matière élastique peut également être disposée sur la face intérieure du support 9 de la seconde partie 2 de boîtier.

Avantageusement, la matière élastique est constituée par une mousse ou une matière à base de silicone. Ainsi, cette matière élastique se comprime pendant la procédure à ultrason tout en amortissant les vibrations engendrées par celle-ci.

Selon une variante, la matière élastique utilisée est une colle, par exemple, de type bi-composant

Avantageusement, la colle utilisée présente une vitesse de polymérisation telle que, tout au long du procédé dé soudure, elle a un degré de viscosité tel que son état est d'une part suffisamment liquide pour s'étaler et , d'autre part , suffisamment solide pour amortir les chocs induits par le sonotrode. Ainsi, la colle s'étale et se conforme à la forme du boîtier et de la carte électronique 3 tout au long du procédé de soudure. La colle ne devient solide qu'après fixation de la seconde partie 2 sur la première partie 1 de boîtier de sorte qu'elle épouse exactement la forme intérieure de la seconde partie 2 de boîtier. Ainsi, les deux parties de boîtier présentent une surface extérieure plane sans bosses indésirables.

Avantageusement, le procédé de fabrication de l'unité d'identification comporte en outre une étape d'étuvage pour accélérer la vitesse de polymérisation.

De préférence, la colle recouvre un ou plusieurs composants électroniques 4 avec une épaisseur e environ égale à la hauteur de la nervure de soudure 6 pour que les vibrations puissent être amorties dès le début de l'étape de soudure.

Avantageusement également, la matière élastique est disposée sur le composant électronique ayant la plus grande hauteur ou, si l'embase n'est pas plate, sur le composant qui est le plus proche de la surface intérieure du support 9 de la seconde partie 1 de boîtier.

## Revendications

1. Procédé de fabrication d'une unité d'identification (8) d'utilisateurs, l'unité d'identification comportant une première (1) et une seconde (2) parties de boîtier et une carte électronique (3) portant des composants électroniques (4) destinés à être connectés entre eux, le rebord (10) de l'une des deux parties de boîtier comportant au moins une nervure de soudure (6) en matière plastique pour permettre une soudure selon un procédé à ultrason, le procédé comportant les étapes suivantes :
- mise en place de la carte électronique (3) dans une première partie (1) de boîtier,
- assemblage de la seconde partie (2) de boîtier sur la première partie (1) de boîtier,
- fixation de la seconde partie (2) de boîtier sur la première partie (1) de boîtier par un procédé de soudure à ultrason,
**caractérisé en qu'**il comporte avant l'étape d'assemblage, une étape intermédiaire de dépôt d'une épaisseur prédéfinie de matière élastique (5) sur au moins une région de la carte électronique (3) et/ou sur au moins une région des première (1) et seconde (2) parties du boîtier, de sorte que pendant l'étape de fixation des deux parties de boîtier, la matière élastique (5) protège les composants électroniques (4), ainsi que leurs connexions, en amortissant les vibrations qui leur sont communiquées.

2. Procédé selon la revendication 1, **caractérisé en que** la matière élastique (5) est une mousse ou une silicone.

3. Procédé selon la revendication 1, **caractérisé en que** la matière élastique (5) est une colle, par exemple, une colle bi-composant.

4. Procédé selon la revendication 3, **caractérisé en que** la colle (5) est destinée à être déposée sur le composant électronique (4) qui est le plus proche de la surface intérieure de la seconde partie (2) de boîtier et/ou en regard de celui-ci pour diminuer la quantité de colle nécessaire à amortir les vibrations induites lors de l'étape de fixation.

5. Procédé selon la revendication 3 ou 4 **caractérisé en qu'**il comporte, entre l'étape de dépôt de colle et l'étape de fixation, une étape de polymérisation de la colle jusqu'à obtention d'un degré de viscosité tel que son état est d'une part suffisamment liquide pour que la colle s'étale entre les deux parties de boîtiers sans déformation de ceux-ci, et d'autre part suffisamment solide pour que la colle amortisse les vibrations communiquées aux composants électroniques ainsi qu'à leurs connexions.

6. Procédé selon l'une des revendications de 3 à 5, **caractérisé en ce que** l'épaisseur prédéfinie de colle est environ égale à l'épaisseur de la nervure de soudure (6) d'une des parties (1, 2) de boîtier, la seconde partie (2) de boîtier étant en contact avec la colle (5) tout au long de l'étape de fixation de manière à amortir les chocs communiqués aux composants électroniques (4) et à étaler la colle de sorte qu'elle soit ajustée exactement entre la première (1) et la deuxième (2) parties de boîtier.

7. Procédé selon l'une des revendications de 3 à 6 **caractérisé en ce qu'**il comporte une étape d'étuvage pour accélérer la vitesse de polymérisation de la colle.

8. Unité d'identification (8) réalisée à partir d'une première (1) et d'une seconde (2) parties de boîtier fixées l'un à l'autre par un procédé de soudure à ultrason, une carte électronique (3) étant disposée à l'intérieur du boîtier et portant des composants électroniques (4) connectés entre eux, **caractérisée en ce qu'**une matière élastique est disposée avec une épaisseur prédéfinie sur au moins une région de la carte électronique et/ou sur au moins une région des première et seconde parties de boîtier de manière à amortir les vibrations dues au procédé de soudure à ultrason et à protéger les composants électroniques ainsi que leurs connexions durant le procédé de soudure.

9. Unité d'identification selon la revendication 8, **caractérisée en ce que** la matière élastique (5) est une colle.

10. Unité d'identification selon la revendication 8, **caractérisée en ce que** la colle est une colle bi-composant.

## Claims

1. Method of manufacturing an identification unit (8) for users, the identification unit comprising a first (1) and a second (2) casing portions and an electronic card (3) supporting electronic components (4) intended to be interconnected, the flange (10) of one of the two casing portions comprising at least one welding bead (6) made of plastic material to allow for a weld by an ultrasonic method, the method comprising the following steps:
- fitting of the electronic card (3) in a first casing portion (1),
- joining the second casing portion (2) to the first casing portion (1),
- fixing of the second casing portion (2) to the first casing portion (1) by an ultrasonic welding method,
**characterized in that** it comprises, prior to the joining step, an intermediate step for deposition of a predefined thickness of elastic material (5) on at least one region of the electronic card (3) and/or on at least one region of the first (1) and second (2) casing portions, so that, during the step for fixing the two casing portions, the elastic material (5) protects the electronic components (4), and their connections, by damping the vibrations that are communicated to them.

2. Method according to Claim 1, **characterized in that** the elastic material (5) is a foam or a silicone.

3. Method according to Claim 1, **characterized in that** the elastic material (5) is a glue, for example, a two-component glue.

4. Method according to Claim 3, **characterized in that** the glue (5) is intended to be deposited on the electronic component (5) which is closest to the inner surface of the second casing portion (2) and/or facing the latter to reduce the quantity of glue needed to damp the vibrations induced during the fixing step.

5. Method according to Claim 3 or 4, **characterized in that** it comprises, between the glue deposition step and the fixing step, a step for polymerization of the glue until a degree of viscosity is obtained such that its state is on the one hand sufficiently liquid for the glue to spread between the two casing portions without deformation thereof, and on the other hand sufficiently solid for the glue to damp the vibrations communicated to the electronic components and to their connections.

6. Method according to one of Claims 3 to 5, **characterized in that** the predefined thickness of glue is approximately equal to the thickness of the welding bead (6) of one of the casing portions (1, 2), the second casing portion (2) being in contact with the glue (5) throughout the fixing step so as to damp the shocks communicated to the electronic components (4) and to spread the glue so that it is precisely fitted between the first (1) and the second (2) casing portions.

7. Method according to one of Claims 3 to 6, **characterized in that** it comprises a baking step to speed up the polymerization rate of the glue.

8. Identification unit (8) produced from a first (1) and a second (2) casing portions fixed to one another by an ultrasonic welding method, an electronic card (3) being arranged inside the casing and supporting interconnected electronic components (4), **characterized in that** an elastic material is arranged with a predefined thickness over at least one region of the electronic card and/or over at least one region of the first and second casing portions so as to damp the vibrations due to the ultrasonic welding method and to protect the electronic components and their connections during the welding method.

9. Identification unit according to Claim 8, **characterized in that** the elastic material (5) is a glue.

10. Identification unit according to Claim 8, **characterized in that** the glue is a two-component glue.

## Patentansprüche

1. Verfahren zur Herstellung einer Einheit (8) zur Identifikation von Benutzern, wobei die Identifikationseinheit ein erstes (1) und ein zweites Gehäuseteil (2) und eine Elektronikkarte (3) aufweist, die elektronische Bauteile (4) trägt, welche dazu bestimmt sind, miteinander verbunden zu werden, wobei die Kante (10) eines der zwei Gehäuseteile mindestens eine Schweißrippe (6) aus Kunststoff aufweist, um ein Schweißen gemäß einem Ultraschallverfahren zu ermöglichen, wobei das Verfahren die folgenden Schritte aufweist:
- Einsetzen der Elektronikkarte (3) in ein erstes Gehäuseteil (1),
- Zusammenbau des zweiten Gehäuseteils (2) mit dem ersten Gehäuseteil (1),
- Befestigen des zweiten Gehäuseteils (2) am ersten Gehäuseteil (1) durch ein Ultraschall-Schweißverfahren,
**dadurch gekennzeichnet, dass** es vor dem Schritt des Zusammenbaus einen Zwischenschritt des Auftragens einer vordefinierten Dicke von Kunststoff (5) auf mindestens einen Bereich der Elektronikkarte (3) und/oder auf mindestens einen Bereich des ersten (1) und zweiten (2) Gehäuseteils enthält, so dass der Kunststoff (5) während des Schritts der Befestigung der zwei Gehäuseteile die elektronischen Bauteile (4) sowie ihre Verbindungen schützt, indem er die auf sie übertragenen Schwingungen dämpft.

2. Verfahren nach Anspruch 1, **dadurch gekennzeichnet, dass** der Kunststoff (5) ein Schaum oder ein Silikon ist.

3. Verfahren nach Anspruch 1, **dadurch gekennzeichnet, dass** der Kunststoff (5) ein Kleber, zum Beispiel ein Zweikomponentenkleber, ist.

4. Verfahren nach Anspruch 3, **dadurch gekennzeichnet, dass** der Kleber (5) dazu bestimmt ist, auf das elektronische Bauteil (4) aufgetragen zu werden, das der Innenfläche des zweiten Gehäuseteils (2), am nächsten und/oder gegenüber diesem angeordnet ist, um die Klebstoffmenge zu reduzieren, die notwendig ist, um die beim Befestigungsschritt induzierten Schwingungen zu dämpfen.

5. Verfahren nach Anspruch 3 oder 4, **dadurch gekennzeichnet, dass** es zwischen dem Schritt des Auftragens von Kleber und dem Befestigungsschritt einen Schritt der Polymerisation des Klebers bis zum Erhalt eines solchen Viskositätsgrads aufweist, dass sein Zustand einerseits ausreichend flüssig ist, damit der Kleber sich zwischen den zwei Gehäuseteilen verteilt, ohne diese zu verformen, und andererseits ausreichend fest ist, damit der Kleber die Schwingungen dämpft, die auf die elektronischen Bauteile und ihre Verbindungen übertragen werden.

6. Verfahren nach einem der Ansprüche 3 bis 5, **dadurch gekennzeichnet, dass** die vordefinierte Kleberdicke in etwa gleich der Dicke der Schweißrippe (6) eines der Gehäuseteile (1, 2) ist, wobei das zweite Gehäuseteil (2) während des ganzen Befestigungsschritts mit dem Kleber (5) in Kontakt ist, um die Stöße zu dämpfen, die auf die elektronischen Bauteile (4) übertragen werden, und um den Kleber so zu verteilen, dass er genau zwischen dem ersten (1) und dem zweiten Gehäuseteil (2) eingepasst wird.

7. Verfahren nach einem der Ansprüche 3 bis 6, **dadurch gekennzeichnet, dass** es einen Schritt des Ausheizens aufweist, um die Polymerisationsgeschwindigkeit des Klebers zu beschleunigen.

8. Identifikationseinheit (8), die ausgehend von einem ersten (1) und einem zweiten (2) Gehäuseteil hergestellt wird, die durch ein Ultraschall-Schweißverfahren aneinander befestigt werden, wobei eine Elektronikkarte (3) im Inneren des Gehäuses angeordnet ist und miteinander verbundene elektronische Bauteile (4) trägt, **dadurch gekennzeichnet, dass** ein Kunststoff mit einer vordefinierten Dicke auf mindestens einem Bereich der Elektronikkarte und/oder auf mindestens einem Bereich des ersten und zweiten Gehäuseteils angeordnet ist, um die Schwingungen aufgrund des Ultraschall-Schweißverfahrens zu dämpfen und die elektronischen Bauteile sowie ihre Verbindungen während des Schweißverfahrens zu schützen.

9. Identifikationseinheit nach Anspruch 8, **dadurch gekennzeichnet, dass** der Kunststoff (5) ein Kleber ist.

10. Identifikationseinheit nach Anspruch 8, **dadurch gekennzeichnet, dass** der Kleber ein Zweikomponentenkleber ist.
